# EUROPEAN PATENT APPLICATION

(11) **EP 4 764 556 A1**
(43) Date of publication of application: **24.06.2026**
(21) Application number: 24877427.5
(22) Date of filing: 23.09.2024
(51) Int. Cl.: G01R 31/396, G01R 31/385, G01R 19/00, G01R 19/10, G01R 19/165, G01R 31/52, G01R 31/392, H01M 10/42

(54) **BATTERY DIAGNOSIS DEVICE AND METHOD FOR OPERATING SAME**

(30) Priority: 13.10.2023 KR 20230137114
(71) Applicant: LG Energy Solution, Ltd., Seoul 07335 (KR)
(72) Inventor: KIM, Young Min, Daejeon 34122 (KR)
(74) Representative: Goddar, Heinz J.
(86) International application number: PCT/KR2024/014275
(87) International publication number: WO 2025/079889

(57) **Abstract**

A battery diagnosis apparatus according to an embodiment disclosed herein includes an obtaining unit configured to obtain open circuit voltage (OCV) data of a plurality of battery units, a deviation calculating unit configured to calculate OCV variances of the plurality of battery units in a first time period, based on the OCV data and calculate an OCV deviation with respect to an average, which is a difference between an average OCV variance of the plurality of battery units and an OCV variance of a target battery unit among the plurality of battery units, a standard deviation calculating unit configured to calculate a first determination value indicating a standard deviation of an OCV deviation with respect to an average for the target battery unit in a second time period, and a diagnosing unit configured to diagnose abnormality of the target battery unit based on the first determination value of the target battery unit.

## Description

### TECHNICAL FIELD

### CROSS-REFERENCE TO RELATED APPLICATION

This application claims priority to and the benefit of Korean Patent Application No. 10-2023-0137114 filed in the Korean Intellectual Property Office on October 13, 2023, the entire content of which is incorporated herein by reference.

### TECHNICAL FIELD

Embodiments disclosed herein relate to a battery diagnosis apparatus and an operating method thereof.

### BACKGROUND ART

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery is generally used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (electric vehicles (EV), hybrid electric vehicles (HEV), plug-in HEV (PHEV)) driven with electricity, large-volume energy storage systems (ESS), etc.

These batteries may be managed and controlled in terms of states and operations thereof by a battery management system (BMS). The battery management system may be included together with a battery in one device.

The battery management system may also manage and control the battery in a state of being spaced apart from a device including the battery. For example, the battery management system may be implemented as a separate server device. In this case, the battery management system may collect battery data and vehicle data from the vehicle, etc., and manage and control the battery using the collected data.

### DISCLOSURE

### TECHNICAL PROBLEM

When a short circuit or a failure of another type occurs inside a battery, the possibility of damage to devices (e.g., EV, ESS) including the battery may increase. Accordingly, there is a need for a scheme to reduce the possibility of damage to devices including a battery by detecting an abnormal state of the battery.

Conventionally, a battery cell has been diagnosed by a calculation scheme using all of a state of charge (SOC), current, capacity, and open circuit voltage (OCV) information. According to such a diagnosis method, because of use of many factors, it may be difficult to perform diagnosis when specific information out of the foregoing information is missing. This may be a big issue in the battery management system implemented with a server device that has to collect data from the vehicle, and may excessively increase memory usage. Thus, there is a need for data simplification required for battery diagnosis.

According to embodiments disclosed herein, there may be provided a battery diagnosis apparatus and an operating method thereof by which abnormality of a battery may be diagnosed merely using battery OCV data information.

Technical problems of the embodiments disclosed herein are not limited to the aforementioned technical problems, and other unmentioned technical problems would be clearly understood by those of ordinary skill in the art from the following description.

### TECHNICAL SOLUTION

A battery diagnosis apparatus according to an embodiment disclosed herein includes an obtaining unit configured to obtain open circuit voltage (OCV) data of a plurality of battery units, a deviation calculating unit configured to calculate OCV variances of the plurality of battery units in a first time period, based on the OCV data and calculate an OCV deviation with respect to an average, which is a difference between an average OCV variance of the plurality of battery units and an OCV variance of a target battery unit among the plurality of battery units, a standard deviation calculating unit configured to calculate a first determination value indicating a standard deviation of an OCV deviation with respect to an average for the target battery unit in a second time period, and a diagnosing unit configured to diagnose abnormality of the target battery unit based on the first determination value of the target battery unit.

In the battery diagnosis apparatus according to an embodiment disclosed herein, the diagnosing unit may be further configured to diagnose the target battery unit as an abnormal battery unit, when the first determination value is greater than or equal to a first threshold value.

The battery diagnosis apparatus according to an embodiment disclosed herein may further include an average calculating unit configured to calculate a second determination value indicating an average of first determination values of the plurality of battery units, in which the diagnosing unit is further configured to diagnose abnormality of a higher-level battery unit including the plurality of battery units, based on the second determination value.

In the battery diagnosis apparatus according to an embodiment disclosed herein, the diagnosing unit may be further configured to diagnose the higher-level battery unit as the abnormal battery unit, when the second determination value is greater than or equal to a second threshold value.

In the battery diagnosis apparatus according to an embodiment disclosed herein, the first time period may be a time period between a point in time before charging of a battery unit and a point in time after the charging.

In the battery diagnosis apparatus according to an embodiment disclosed herein, the obtaining unit may be further configured to obtain time-series voltage data and time-series current data of the plurality of battery units and obtain the OCV data having a designated current value and a designated voltage range, based on the time-series voltage data and the time-series current data.

The battery diagnosis apparatus according to an embodiment disclosed herein may further include an abnormality processing unit configured to perform an abnormality processing function based on an abnormality diagnosis result of each of the plurality of battery units, in which the abnormality processing function includes a notification function or a short-circuit function.

A battery diagnosis method according to an embodiment disclosed herein includes obtaining open circuit voltage (OCV) data of a plurality of battery units, calculating OCV variances of the plurality of battery units in first time period, based on the OCV data, calculating an OCV deviation with respect to an average, which is a difference between an average OCV variance of the plurality of battery units and an OCV variance of a target battery unit among the plurality of battery units, calculating a first determination value indicating a standard deviation of an OCV deviation with respect to an average for the target battery unit in a second time period, and diagnosing abnormality of the target battery unit based on the first determination value of the target battery unit.

In the battery diagnosis method according to an embodiment disclosed herein, the diagnosing of abnormality of the target battery unit may include diagnosing the target battery unit as an abnormal battery unit when the first determination value is greater than or equal to a first threshold value.

The battery diagnosis method according to an embodiment disclosed herein may further include calculating a second determination value indicating an average of first determination values of the plurality of battery units and diagnosing abnormality of a higher-level battery unit including the plurality of battery units, based on the second determination value.

In the battery diagnosis method according to an embodiment disclosed herein, the diagnosing of abnormality of the higher-level battery unit may include diagnosing the higher-level battery unit as the abnormal battery unit when the second determination value is greater than or equal to a second threshold value.

In the battery diagnosis method according to an embodiment disclosed herein, the first time period may be a time period between a point in time before charging of a battery unit and a point in time after the charging.

In the battery diagnosis method according to an embodiment disclosed herein, the obtaining of the OCV data of the plurality of battery units may include obtaining time-series voltage data and time-series current data of the plurality of battery units and obtaining the OCV data having a designated current value and a designated voltage range, based on the time-series voltage data and the time-series current data.

The battery diagnosis method according to an embodiment disclosed herein may further include performing an abnormality processing function based on an abnormality diagnosis result of each of the plurality of battery units, in which the abnormality processing function includes a notification function or a short-circuit function.

### ADVANTAGEOUS EFFECTS

According to embodiments disclosed herein, data used for abnormality diagnosis of a battery may be simplified.

According to embodiments disclosed herein, the accuracy of battery abnormality diagnosis may be improved and a diagnosis over-detection rate may be reduced.

In addition, various effects identified directly or indirectly through this document may be provided.

### DESCRIPTION OF DRAWINGS

FIG. 1 is a block diagram of a battery diagnosis apparatus according to an embodiment.
FIG. 2 is a graph showing an open circuit voltage (OCV) deviation with respect to an average for a battery unit, calculated by a battery diagnosis apparatus according to an embodiment.
FIG. 3 is a graph showing a standard deviation of a battery unit, calculated by a battery diagnosis apparatus according to an embodiment.
FIG. 4 is an operating flowchart of a battery diagnosis apparatus according to an embodiment.
FIG. 5 is an operating flowchart of a battery diagnosis apparatus according to an embodiment.

### MODE FOR INVENTION

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element).

According to various embodiments of the disclosure, each of the above-described components (e.g., a module or program) may include a single entity or a plurality of entities, some of which may be separately disposed on other components. According to various embodiments of the disclosure, one or more of the above-described components or operations may be omitted or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

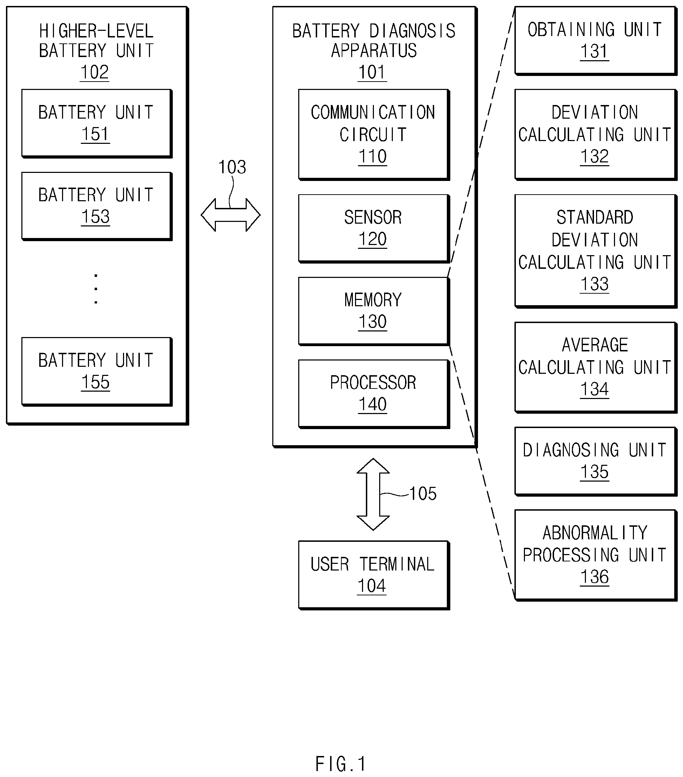

FIG. 1 is a block diagram of a battery diagnosis apparatus according to an embodiment.

Referring to FIG. 1, a higher-level battery unit 102 may include a plurality of battery units 151, 153, and 155. According to an embodiment, the higher-level battery unit 102 may be a battery pack mounted inside an electric vehicle to supply power to the electric vehicle or a battery module included in the battery pack. When the higher-level battery unit 102 is the battery pack, the plurality of battery units 151, 153, and 155 may be a plurality of battery modules or a plurality of battery cells. When the higher-level battery unit 102 is the battery module, the plurality of battery units 151, 153, and 155 may be a plurality of battery cells.

According to an embodiment, the battery diagnosis apparatus 101 may be formed integrally with the higher-level battery unit 102. In this case, the battery diagnosis apparatus 101 may be included in a battery management system (BMS) of the higher-level battery unit 102.

According to an embodiment, the battery diagnosis apparatus 101 may be formed separately from the higher-level battery unit 102. In this case, the battery diagnosis apparatus 101 may be implemented as an external server connected to the higher-level battery unit 102 and/or the battery unit 151, 153, and/or 155 through a wireless network.

According to an embodiment, the battery diagnosis apparatus 101 may be wiredly and/or wirelessly connected to the higher-level battery unit 102 and a user terminal 104.

According to an embodiment, connection 103 between the battery diagnosis apparatus 101 and the higher-level battery unit 102 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4th-Generation (4G) network, a 5th-Generation (5G) network).

According to another embodiment, the connection 103 between the battery diagnosis apparatus 101 and the higher-level battery unit 102 may be connection using a device-to-device communication scheme (e.g., a bus, a general-purpose input and output (GPIO), a serial peripheral interface (SPI), or a mobile industry processor interface (MIPI)).

According to an embodiment, connection 105 between the battery diagnosis apparatus 101 and the user terminal 104 may be communication connection through a wired and/or wireless network.

According to an embodiment, the user terminal 104 may be a mobile device (e.g., a mobile phone, a laptop computer, a smart phone, a smart pad), or a personal computer (PC). According to an embodiment, the battery diagnosis apparatus 101 may provide information related to a diagnosis result of the battery unit 151, 153, or 155 to the user terminal 104.

According to an embodiment, the battery diagnosis apparatus 101 may include a communication circuit 110, a sensor 120, a memory 130, and a processor 140. According to an embodiment, the battery diagnosis apparatus 101 shown in FIG. 1 may further include at least one component (e.g., a display, an input device, or an output device) in addition to the components shown in FIG. 1, or at least one component (e.g., the sensor 120) among the components shown in FIG. 1 may be omitted. For example, when the battery diagnosis apparatus 101 is implemented as a separate external electronic device from the higher-level battery unit 102, such as a server, a cloud, etc., the battery diagnosis apparatus 101 may obtain state information of the plurality of battery units 151, 153, and 155 by using the communication circuit 110. In this case, the battery diagnosis apparatus 101 may not include the sensor 120.

According to an embodiment, the communication circuit 110 may establish a wired communication channel and/or a wireless communication channel between the battery diagnosis apparatus 101 and the higher-level battery unit 102 and/or the user terminal 104, and transmit and receive data to and from higher-level battery unit 102 and/or the user terminal 104 through the established communication channel.

According to an embodiment, the sensor 120 may measure information (e.g., voltage, current, temperature, etc.,) related to states of the plurality of battery units 151, 153, and 155 of the higher-level battery unit 102. For example, when the battery diagnosis apparatus 101 is implemented as a BMS in an electronic device, the battery diagnosis apparatus 101 may directly measure states of the plurality of battery units 151, 153, and 155 by using the sensor 120.

According to an embodiment, the communication circuit 110 and/or the sensor 120 may obtain time-series data related to the states of the battery units 151, 153, and 155. In an embodiment, the time-series data related to the states of the plurality of battery units 151, 153, and 155 may include data indicating voltages, currents, resistances, states of charge (SOC), states of health (SOH), and/or temperatures with respect to time.

According to an embodiment, the memory 130 may include a volatile and/or a nonvolatile memory.

According to an embodiment, the memory 130 may store data used by at least one component (e.g., the processor 140) of the battery diagnosis apparatus 101. For example, the data may include software (or an instruction related thereto), input data, or output data. In an embodiment, the instruction, when executed by the processor 140, may cause the battery abnormality diagnosis apparatus 101 to perform operations defined by the instruction.

According to an embodiment, the memory 140 may include one or more software (e.g., an obtaining unit 131, a deviation calculating unit 132, a standard deviation calculating unit 133, an average calculating unit 134, a diagnosing unit 135, and an abnormality processing unit 136).

According to an embodiment, the processor 140 may include a central processing unit, an application processor, a graphic processing unit, a neural processing unit (NPU), an image signal processor, a sensor hub processor, or a communication processor.

According to an embodiment, the processor 140 may execute software (e.g., the obtaining unit 131, the deviation calculating unit 132, the standard deviation calculating unit 133, the average calculating unit 134, the diagnosing unit 135, and the abnormality processing unit 136) stored in the memory 130 to control at least one other component (e.g., a hardware or software component) of the battery diagnosis apparatus 101 connected to the processor 140 and perform various data processing or operations.

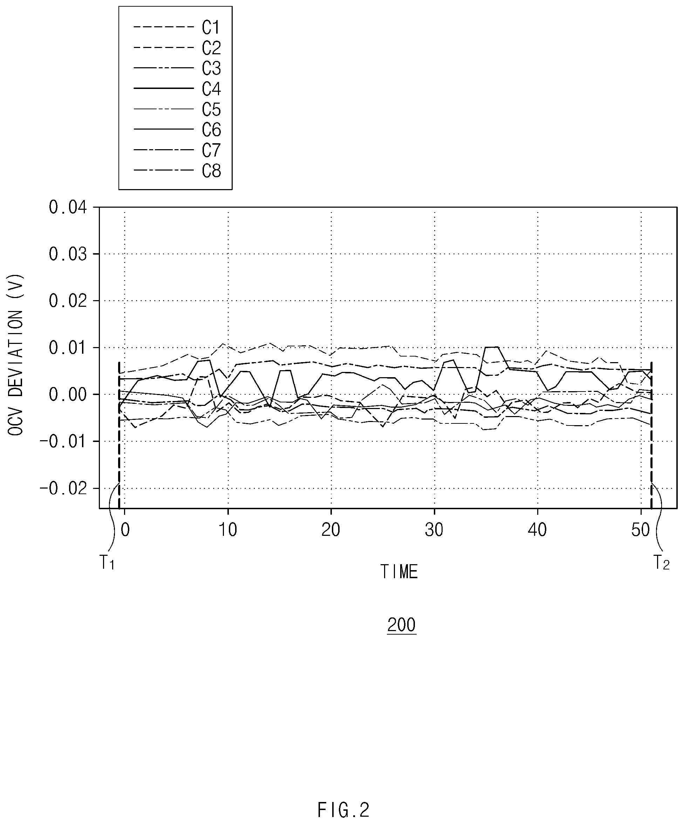

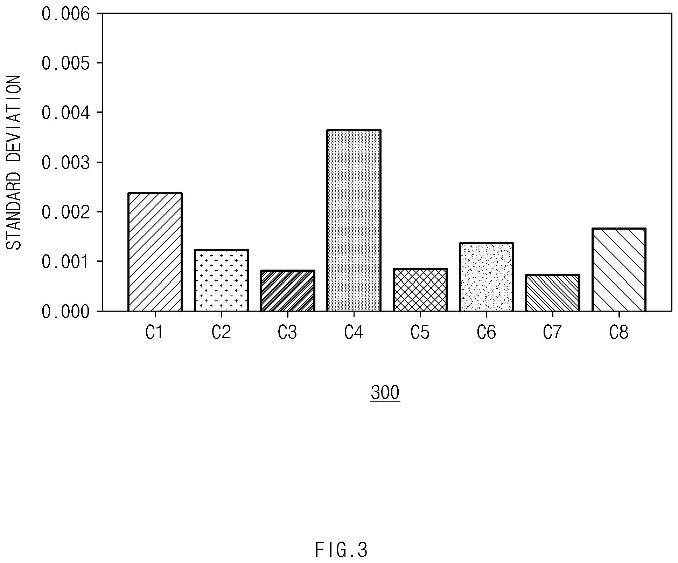

Hereinbelow, referring to FIGS. 2 and 3, a description will be made of a method, performed by the battery diagnosis apparatus 101, of diagnosing abnormality of the plurality of battery units 151, 153, and 155 through the obtaining unit 131, the deviation calculating unit 132, the standard deviation calculating unit 133, the average calculating unit 134, the diagnosing unit 135, and the abnormality processing unit 136.

FIG. 2 is a graph showing an open circuit voltage (OCV) deviation with respect to an average for a battery unit, calculated by a battery diagnosis apparatus according to an embodiment. FIG. 3 is a graph showing a standard deviation of a battery unit, calculated by a battery diagnosis apparatus according to an embodiment.

According to an embodiment, the obtaining unit 131 may obtain OCV data of the plurality of battery units 151, 153, and 155. According to an embodiment, the obtaining unit 131 may obtain the OCV data by using the communication circuit 110 and/or the sensor 120.

According to an embodiment, the obtaining unit 131 may obtain time-series voltage data and time-series current data of the plurality of battery units 151, 153, and 155. In this case, the obtaining unit 131 may obtain the OCV data based on the time-series voltage data and the time-series current data. For example, the obtaining unit 131 may obtain, as the OCV data, data of the time-series voltage data and the time-series current data, which satisfies a designated current value (e.g., 0 A) and a designated voltage range.

According to an embodiment, the deviation calculating unit 132 may calculate an OCV deviation with respect to an average for a target battery unit 151, 153, or 155 based on the OCV data obtained by the obtaining unit 131.

According to an embodiment, the deviation calculating unit 132 may extract OCV data in a designated voltage range (e.g., 0.4 V or greater) from the OCV data. The deviation calculating unit 132 may calculate an OCV deviation with respect to an average based on the extracted OCV data in the designated voltage range.

According to an embodiment, the deviation calculating unit 132 may calculate an OCV variance in a first time period for each of the plurality of battery units 151, 153, and 155, based on the OCV data. According to an embodiment, the first time period may be set a time period between a point in time before charging is performed on the battery unit 151, 153, or 155 and a point in time after the charging is performed. For example, the deviation calculating unit 132 may calculate an OCV variance that is a difference between an OCV at the point in time before charging is performed and an OCV at the point in time after the charging is performed, based on the OCV data of the battery unit 151, 153, or 155.

According to an embodiment, the deviation calculating unit 132 may calculate an OCV deviation with respect to the average of the target battery unit 151, 153, or 155 based on the OCV variances of the plurality of battery units 151, 153, and 155. According to an embodiment, the deviation calculating unit 132 may calculate a difference (e.g., a difference = average OCV variance - OCV variance of target battery unit) between an average OCV variance of the plurality of battery units 151, 153, and 155 and the OCV variance of the target battery unit 151, 153, or 155.

Referring to FIG. 2, a graph 200 is shown which indicates an OCV deviation with respect to an average of diagnosis target battery units C1, C2, C3, C4, C5, C6, C7, and C8, calculated by the deviation calculating unit 132.

In the graph 200, an X-axis may indicate time and a Y-axis may indicate an OCV deviation with respect to an average (a difference between an average OCV variance of diagnosis target battery units and an OCV variance of each battery unit). The graph 200 may indicate the OCV deviation with respect to the average of the diagnosis target battery units C1, C2, C3, C4, C5, C6, C7, and C8 from a first point in time T₁ to a second point in time T₂.

According to an embodiment, the deviation calculating unit 132 may calculate an OCV deviation with respect to an average of diagnosis target battery units every designated periods. The battery diagnosis apparatus 101 may cumulatively store the OCV deviation with respect to the average, calculated by the deviation calculating unit 132, in the memory 130 for a designated time to manage OCV deviation data as shown in the graph 200.

Referring back to FIG. 1, the standard deviation calculating unit 133 may calculate a first determination value indicating a standard deviation of OCV deviations with respect to the average for the target battery unit 151, 153, or 155 in the second time period, calculated by the deviation calculating unit 132. For example, when the standard deviation calculating unit 133 calculates the first determination value based on OCV deviation data-to-average of the graph 200 of FIG. 2, the second time period may be included in a time period from the first point in time T₁ to the second point in time T₂ of FIG. 2.

Referring to FIG. 3, a graph 300 is shown which indicates a standard deviation of the diagnosis target battery units C1, C2, C3, C4, C5, C6, C7, and C8. In the graph 300, an X-axis indicates a battery unit number and a Y-axis indicates a standard deviation.

Referring back to FIG. 1, the diagnosing unit 135 may diagnose abnormality of the target battery unit 151, 153, or 155 based on the first determination value of the target battery unit 151, 153, or 155, calculated by the standard deviation calculating unit 133. For example, the diagnosing unit 135 may diagnose a low capacity of the target battery unit 151, 153, or 155.

According to an embodiment, the diagnosing unit 135 may diagnose abnormality of the target battery unit 151, 153, or 155 by comparing the first determination value with a first threshold value previously stored in the memory 130. For example, the diagnosing unit 135 may diagnose the target battery unit 151, 153, or 155 as an abnormal battery unit when the first determination value is greater than or equal to the first threshold value.

According to an embodiment, the diagnosing unit 135 may diagnose abnormality of the plurality of battery units 151, 153, and 155 based on the first determination value of each of the plurality of battery units 151, 153, and 155.

According to an embodiment, the average calculating unit 134 may calculate a second determination value indicating an average of the first determination values of the plurality of battery units 151, 153, and 155.

According to an embodiment, the diagnosing unit 135 may diagnose abnormality of the higher-level battery unit 102 including the plurality of battery units 151, 153, and 155 based on the second determination value.

According to an embodiment, the diagnosing unit 135 may diagnose abnormality of the higher-level battery unit 102 by comparing the second determination value with a second threshold value previously stored in the memory 130. For example, the diagnosing unit 135 may diagnose the higher-level battery unit 102 as an abnormal battery unit when the second determination value is greater than or equal to the second threshold value.

According to an embodiment, the abnormality processing unit 136 may perform an abnormality processing function based on abnormality diagnosis results for the plurality of battery units 151, 153, and 155. Herein, the abnormality processing function may include a notification function or a short-circuit function.

According to an embodiment, the abnormality processing unit 136 may transmit the abnormality diagnosis results for the plurality of battery units 151, 153, and 155 to the user terminal 104 connected through a wired and/or wireless network.

According to an embodiment, the abnormality processing unit 136 may isolate an abnormal battery unit from the electronic device based on the abnormality diagnosis results for the plurality of battery units 151, 153, and 155. Herein, isolation may include electrical and/or mechanical isolation.

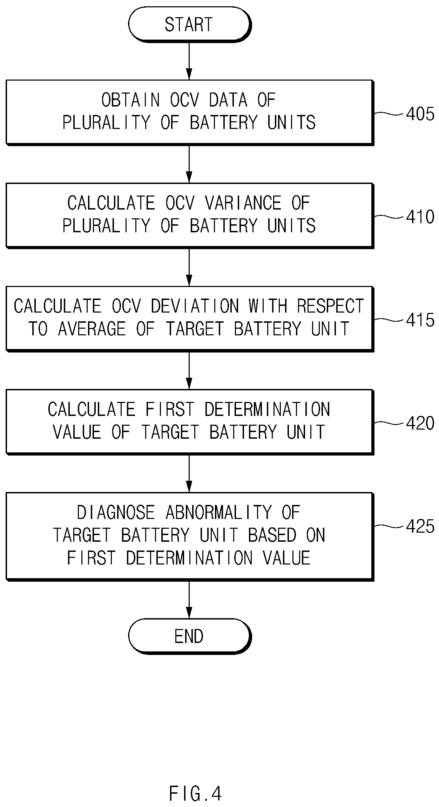

FIG. 4 is an operating flowchart of a battery diagnosis apparatus according to an embodiment. FIG. 4 will be described using the components of FIG. 1.

An embodiment shown in FIG. 4 is merely an embodiment, and an order of operations according to various embodiments of the present disclosure may be different from that shown in FIG. 4, some operations shown in FIG. 4 may be omitted, or an order of the operations may be changed or operations may be merged.

Referring to FIG. 4, in operation 405, the battery diagnosis apparatus 101 may obtain OCV data of the plurality of battery units 151, 153, and 155. According to an embodiment, the battery diagnosis apparatus 101 may obtain the OCV data by using the communication circuit 110 and/or the sensor 120.

According to an embodiment, the battery diagnosis apparatus 101 may obtain time-series voltage data and time-series current data of the plurality of battery units 151, 153, and 155. In this case, the battery diagnosis apparatus 101 may obtain the OCV data based on the time-series voltage data and the time-series current data. For example, the battery diagnosis apparatus 101 may obtain, as the OCV data, data of the time-series voltage data and the time-series current data, which satisfies a designated current value (e.g., 0 A) and a designated voltage range.

In operation 410, the battery diagnosis apparatus 101 may calculate an OCV variance in the first time period for each of the plurality of battery units 151, 153, and 155, based on the OCV data obtained in operation 405. According to an embodiment, the first time period may be set to be a time period between a point in time before charging is performed on the battery unit 151, 153, or 155 and a point in time after the charging is performed. For example, the battery diagnosis apparatus 101 may calculate an OCV variance that is a difference between an OCV at the point in time before charging is performed and an OCV at the point in time after the charging is performed, based on the OCV data of the battery unit 151, 153, or 155.

According to an embodiment, the battery diagnosis apparatus 101 may extract OCV data in a designated voltage range (e.g., 0.4 V or greater) from the OCV data. The battery diagnosis apparatus 101 may calculate the OCV variance based on the extracted OCV data in the designated voltage range.

In operation 415, the battery diagnosis apparatus 101 may calculate an OCV deviation with respect to the average of the target battery unit 151, 153, or 155 based on the OCV variances of the plurality of battery units 151, 153, and 155, calculated in operation 410.

According to an embodiment, the battery diagnosis apparatus 101 may calculate, as the OCV deviation with respect to the average, a difference (e.g., a difference = average OCV variance - OCV variance of target battery unit) between an average OCV variance of the plurality of battery units 151, 153, and 155 and the OCV variance of the target battery unit 151, 153, or 155.

In operation 420, the battery diagnosis apparatus 101 may calculate the first determination value of the target battery unit 151, 153, or 155. Herein, the first determination value may indicate a standard deviation of the OCV deviations with respect to the average of the target battery unit 151, 153, or 155 in the second time period.

In operation 425, the battery diagnosis apparatus 101 may diagnose abnormality of the target battery unit 151, 153, or 155 based on the first determination value calculated in operation 420. For example, the battery diagnosis apparatus 101 may diagnose a low capacity of the target battery unit 151, 153, or 155.

According to an embodiment, the battery diagnosis apparatus 101 may diagnose abnormality of the target battery unit 151, 153, or 155 by comparing the first determination value with a first threshold value previously stored in the memory 130. For example, the battery diagnosis apparatus 101 may diagnose the target battery unit 151, 153, or 155 as an abnormal battery unit when the first determination value is greater than or equal to the first threshold value.

According to an embodiment, the battery diagnosis apparatus 101 may diagnose abnormality of the plurality of battery units 151, 153, and 155 based on the first determination value of each of the plurality of battery units 151, 153, and 155.

According to an embodiment, the battery diagnosis apparatus 101 may perform an abnormality processing function based on abnormality diagnosis results for the plurality of battery units 151, 153, and 155. Herein, the abnormality processing function may include a notification function or a short-circuit function.

According to an embodiment, the battery diagnosis apparatus 101 may transmit the abnormality diagnosis results for the plurality of battery units 151, 153, and 155 to the user terminal 104 connected through a wired and/or wireless network.

According to an embodiment, the battery diagnosis apparatus 101 may isolate an abnormal battery unit from the electronic device based on the abnormality diagnosis results for the plurality of battery units 151, 153, and 155. Herein, isolation may include electrical and/or mechanical isolation.

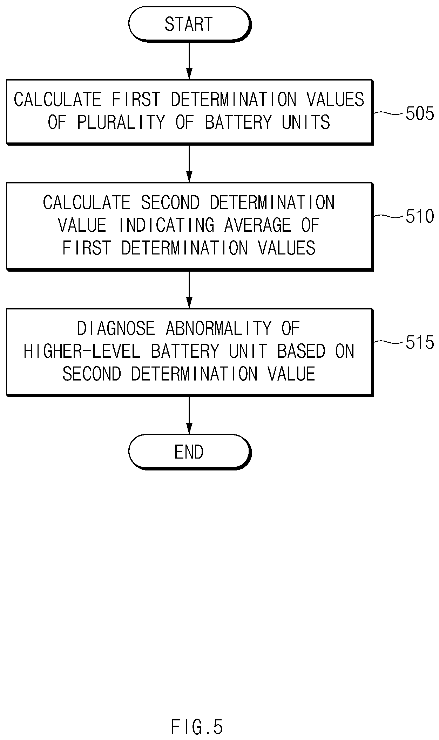

FIG. 5 is an operating flowchart of a battery diagnosis apparatus according to an embodiment. FIG. 5 will be described using the components of FIG. 1.

An embodiment shown in FIG. 5 is merely an embodiment, and an order of operations according to various embodiments of the present disclosure may be different from that shown in FIG. 5, some operations shown in FIG. 5 may be omitted, or an order of the operations may be changed or operations may be merged.

Referring to FIG. 5, in operation 505, the battery diagnosis apparatus 101 may calculate first determination values of the plurality of battery units 151, 153, and 155. Herein, the first determination values may indicate standard deviations of the OCV deviations with respect to the average for each of the plurality of target battery units 151, 153, and 155 in the second time period.

In operation 510, the battery diagnosis apparatus 101 may calculate the second determination value indicating an average of the first determination values calculated in operation 505.

In operation 515, the battery diagnosis apparatus 101 may diagnose abnormality of the higher-level battery unit 102 including the plurality of target battery units 151, 153, and155 based on the second determination value calculated in operation 510.

According to an embodiment, the battery diagnosis apparatus 101 may diagnose abnormality of the higher-level battery unit 102 by comparing the second determination value with a second threshold value previously stored in the memory 130. For example, the battery diagnosis apparatus 101 may diagnose the higher-level battery unit 102 as an abnormal battery unit when the second determination value is greater than or equal to the second threshold value.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

## Claims

1. A battery diagnosis apparatus comprising:
an obtaining unit configured to obtain open circuit voltage (OCV) data of a plurality of battery units;
a deviation calculating unit configured to calculate OCV variances of the plurality of battery units in a first time period, based on the OCV data and calculate an OCV deviation with respect to an average, which is a difference between an average OCV variance of the plurality of battery units and an OCV variance of a target battery unit among the plurality of battery units;
a standard deviation calculating unit configured to calculate a first determination value indicating a standard deviation of an OCV deviation with respect to an average for the target battery unit in a second time period; and
a diagnosing unit configured to diagnose abnormality of the target battery unit based on the first determination value of the target battery unit.

2. The battery diagnosis apparatus of claim 1, wherein the diagnosing unit is further configured to diagnose the target battery unit as an abnormal battery unit, when the first determination value is greater than or equal to a first threshold value.

3. The battery diagnosis apparatus of claim 1, further comprising an average calculating unit configured to calculate a second determination value indicating an average of first determination values of the plurality of battery units,
wherein the diagnosing unit is further configured to diagnose abnormality of a higher-level battery unit comprising the plurality of battery units, based on the second determination value.

4. The battery diagnosis apparatus of claim 3, wherein the diagnosing unit is further configured to diagnose the higher-level battery unit as the abnormal battery unit, when the second determination value is greater than or equal to a second threshold value.

5. The battery diagnosis apparatus of claim 1, wherein the first time period is a time period between a point in time before charging of a battery unit and a point in time after the charging.

6. The battery diagnosis apparatus of claim 1, wherein the obtaining unit is further configured to:
obtain time-series voltage data and time-series current data of the plurality of battery units; and
obtain the OCV data having a designated current value and a designated voltage range, based on the time-series voltage data and the time-series current data.

7. The battery diagnosis apparatus of claim 1, further comprising an abnormality processing unit configured to perform an abnormality processing function based on an abnormality diagnosis result of each of the plurality of battery units,
wherein the abnormality processing function comprises a notification function or a short-circuit function.

8. A battery diagnosis method comprising:
obtaining open circuit voltage (OCV) data of a plurality of battery units;
calculating OCV variances of the plurality of battery units in first time period, based on the OCV data;
calculating an OCV deviation with respect to an average, which is a difference between an average OCV variance of the plurality of battery units and an OCV variance of a target battery unit among the plurality of battery units;
calculating a first determination value indicating a standard deviation of an OCV deviation with respect to an average for the target battery unit in a second time period; and
diagnosing abnormality of the target battery unit based on the first determination value of the target battery unit.

9. The battery diagnosis method of claim 8, wherein the diagnosing of abnormality of the target battery unit comprises diagnosing the target battery unit as an abnormal battery unit when the first determination value is greater than or equal to a first threshold value.

10. The battery diagnosis method of claim 8, further comprising:
calculating a second determination value indicating an average of first determination values of the plurality of battery units; and
diagnosing abnormality of a higher-level battery unit comprising the plurality of battery units, based on the second determination value.

11. The battery diagnosis method of claim 10, wherein the diagnosing of abnormality of the higher-level battery unit comprises diagnosing the higher-level battery unit as the abnormal battery unit when the second determination value is greater than or equal to a second threshold value.

12. The battery diagnosis method of claim 8, wherein the first time period is a time period between a point in time before charging of a battery unit and a point in time after the charging.

13. The battery diagnosis method of claim 8, wherein the obtaining of the OCV data of the plurality of battery units comprises:
obtaining time-series voltage data and time-series current data of the plurality of battery units; and
obtaining the OCV data having a designated current value and a designated voltage range, based on the time-series voltage data and the time-series current data.

14. The battery diagnosis method of claim 8, further comprising performing an abnormality processing function based on an abnormality diagnosis result of each of the plurality of battery units,
wherein the abnormality processing function comprises a notification function or a short-circuit function.
